# EUROPÄISCHE PATENTSCHRIFT

(11) **EP 3 234 972 B1**
(45) Veröffentlichungstag und Bekanntmachung des Hinweises auf die Patenterteilung: **20.02.2019**
(21) Anmeldenummer: 15807601.8
(22) Anmeldetag: 27.11.2015
(51) Int. Cl.: H01H 3/02

(54) **EINGABEEINRICHTUNG ZUM ERMITTELN EINER MANUELLEN BETÄTIGUNG**
INPUT DEVICE FOR DETECTING A MANUAL ACTUATION
DISPOSITIF DE SAISIE POUR LA DÉTECTION D'UN ACTIONNEMENT MANUEL

(30) Priorität: 19.12.2014 DE 102014019241
(43) Veröffentlichungstag der Anmeldung: 25.10.2017
(73) Patentinhaber: Audi AG, 85045 Ingolstadt (DE)
(72) Erfinder: KÜHNER, Manuel, 71706 Markgröningen (DE); WACHINGER, Michael, 86571 Winkelhausen (DE); MÜLLER, Ulrich, 85055 Ingolstadt (DE)
(74) Vertreter: Brandt, Kai
(86) Internationale Anmeldenummer: PCT/EP2015/002388
(87) Internationale Veröffentlichungsnummer: WO 2016/096089

(56) Entgegenhaltungen:
- EP-A1- 2 434 645
- WO-A1-2011/018439
- DE-A1-102009 032 634
- US-A1- 2011 241 442

## Beschreibung

Die vorliegende Erfindung betrifft eine Eingabeeinrichtung zum Ermitteln einer manuellen Betätigung, mit einem berührungssensitiven Sensorelement, welches in einer Betätigungsrichtung der manuellen Betätigung bewegbar gelagert ist. Darüber hinaus betrifft die Erfindung auch ein Fahrzeug mit einer Eingabeeinrichtung.

Betätigungseinrichtungen der gattungsgemäßen Art sind insbesondere auch beim Einsatz bei Fahrzeugen dem Grunde nach bekannt, sodass eines gesonderten druckschriftlichen Nachweises hierfür nicht bedarf. Eingabeeinrichtungen sind beispielsweise berührungssensitive Taster, mittels welchen ein Fahrzeuginsasse eines Fahrzeugs durch Berührung eine Steuerfunktion aktivieren und/oder deaktivieren kann. Derartige Steuerfunktionen können beispielsweise eine Senderwahl bei einem Autoradio, eine Aktivierung beziehungsweise Deaktivierung eines Scheibenwischers, Einstellen eines automatisch einstellbaren Spiegels, Kombinationen hiervon und/oder dergleichen sein.

Gerade bei Fahrzeugen, aber auch bei anderen Umgebungen, die äußeren mechanischen Einflüssen verstärkt ausgesetzt sind, kann das Problem auftreten, dass eine Betätigung durch eine unvorhergesehene Bewegung des Fahrzeugs beziehungsweise einer Stand- beziehungsweise Sitzfläche des Betätigenden gestört wird. So kann aufgrund der Störwirkung die ursprünglich vorgesehene Eingabefunktion aufgrund der Störung an einer unerwünscht verschobenen Stelle oder zu einem unerwünscht zeitlich verschobenen Zeitpunkt erfolgen. Die hierdurch erzeugte Unsicherheit der Eingabefunktion kann zwar durch entsprechende weitere Eingaben in der Regel wieder rückgängig gemacht werden, jedoch ist dies aufwändig und umständlich. Gerade wenn der Betätigende ein Fahrer eines Fahrzeugs ist, erweist sich dies als besonders nachteilig, weil der Fahrer durch die nunmehr erforderliche Vielzahl von weiteren Eingabeschritten von seiner eigentlichen Fahraufgabe abgelenkt sein kann.
Eine solche Betätigungseinrichtung offenbart beispielsweise die DE 10 2012 203 831 A1. Bei dieser Betätigungseinrichtung ist das Sensorelement in Betätigungsrichtung bewegbar gelagert. Mittels einer Feder ist das Sensorelement entgegen einer Betätigungskraft vorgespannt. Wird das Sensorelement in Betätigungsrichtung betätigt, betätigt dieses, nachdem es um einen vorgegebenen Hub verschoben worden ist, ein elektrisches Schaltelement. Eine Kraftmessung erfolgt nicht. Gerade bei einem Einsatz bei Fahrzeugen erweist es sich als nachteilig, dass eine Verbindung des Sensorelements mit dem Schaltelement nicht gegeben ist. Dies kann zu Geräuschen und auch zu Fehlfunktionen führen. Die Vorspannung entgegen einer Betätigungskraft fördert diesen Nachteil noch. Das Dokument "EP 2 434 645 A1" offenbart eine Eingabeeinrichtung gemäß dem Oberbegriff des Patentanspruchs 1.

Es ist deshalb die Aufgabe der Erfindung, eine zuverlässigere Eingabemöglichkeit beziehungsweise Steuermöglichkeit für einen Benutzer beziehungsweise den Bedienenden zu schaffen.
Als Lösung wird mit der Erfindung vorgeschlagen, dass bei einer gattungsgemäßen Eingabeeinrichtung das berührungssensitive Sensorelement mit einem Kraftsensorelement mechanisch gekoppelt ist.
Fahrzeugseitig wird vorgeschlagen, dass das Fahrzeug eine Eingabeeinrichtung gemäß der Erfindung aufweist.
Mit der Erfindung wird erstmals vorgeschlagen, das berührungssensitive Sensorelement mechanisch mit dem Kraftsensorelement zu koppeln, um mittels Auswerten eines Kraftsignals des Kraftsensorelements eine verbesserte Entscheidung treffen zu können, ob eine mittels des berührungssensitiven Sensorelements erfasste Betätigung einer vom Betätigenden gewollten Betätigung auch tatsächlich entspricht. Dabei geht die Erfindung davon aus, dass bei einer gewollten Betätigung durch den Betätigenden nicht nur eine Berührung des berührungssensitiven Elements stattfindet, sondern ergänzend auch eine Krafteinwirkung vorliegt. Regelmäßig tritt ein solcher Fall beispielsweise auf, wenn der Betätigende beispielsweise bei einem berührungssensitiven Bildschirm während der Suche nach einer gewünschten Funktion mit seinem Finger über den Bildschirm fährt. Sobald er die gewünschte Funktion aufgefunden hat, drückt er in der Regel mit einer Druckkraft auf den Bildschirm, um die gewünschte ausgewählte Funktion aktivieren zu können. Der berührungssensitive Bildschirm erfasst jedoch häufig auch Positionen des Fingers, die während des Verfahrens des Fingers über die Bildschirmoberfläche erfasst worden sind. Dadurch werden häufig eine Reihe von unerwünschten Betätigungen erfasst, die der Bedienende dem Grunde nach jedoch gar nicht aktivieren wollte. Mit der Erfindung kann dies vermieden werden. Dadurch, dass das berührungssensitive Sensorelement mechanisch mit dem Kraftsensorelement gekoppelt ist, kann erreicht werden, dass eine Betätigung nur dann erfasst wird, wenn zugleich auch eine hinreichend große Kraftwirkung erfasst wird. Zu diesem Zweck ist das berührungssensitive Sensorelement bewegbar gelagert, sodass eine Kraftwirkung auf das berührungssensitive Sensorelement zu einer Einwirkung auf das Kraftsensorelement führen kann. Dadurch kann mittels des Kraftsensorelements die vom Finger des Bedienenden aufgebrachte Druckkraft erfasst werden.

Die Eingabeeinrichtung kann beispielsweise ein berührungssensitiver Bildschirm eines Navigationsgeräts sein. Darüber hinaus kann die Eingabeeinrichtung aber auch eine berührungssensitive Taste sein, die zum Aktivieren beziehungsweise Deaktivieren einer Steuerfunktion des Fahrzeugs dient. Eine solche Funktion kann beispielsweise das Einschalten eines Lichts, das Betätigen einer Feststellbremse, das Umschalten einer Getriebecharakteristik, Kombinationen hiervon und/oder dergleichen sein. Darüber hinaus kann die Eingabeeinrichtung auch mit einem Radio, insbesondere bei einem Fahrzeug ein Autoradio, oder dergleichen verbunden sein.

Vorzugsweise ist das Kraftsensorelement lediglich in einer Vorzugsrichtung sensitiv in Bezug auf eine einwirkende Kraft, wobei das Kraftsensorelement vorzugsweise derart mit dem berührungssensitiven Sensorelement verbunden ist, dass seine Vorzugsrichtung im Wesentlichen mit der zu erwartenden Druckeinwirkung auf das berührungssensitive Sensorelement übereinstimmt. Dadurch kann die Genauigkeit der erfassten Betätigung weiter verbessert werden.

Die mechanische Kopplung zwischen dem berührungssensitiven Sensorelement und dem Kraftsensorelement kann im einfachsten Fall dadurch hergestellt sein, dass das Kraftsensorelement am berührungssensitiven Sensorelement anliegt. Darüber hinaus kann auch ein Kopplungselement vorgesehen sein, welches durch ein im Wesentlichen im bestimmungsgemäßen Betrieb starres Element gebildet ist, und welches eine Kraftwirkung vom berührungssensitiven Sensorelement auf das Kraftsensorelement zu übertragen vermag. Durch die bewegbare Lagerung kann sichergestellt werden, dass die Kraftwirkung aufgrund einer Betätigung auch auf das Kraftsensorelement übertragen wird.

Vorzugsweise umfasst die Eingabeeinrichtung auch eine Auswerteeinheit, an die das berührungssensitive Sensorelement und das Kraftsensorelement angeschlossen sind. Die Auswerteeinheit wertet von dem berührungssensitiven Sensorelement und dem Kraftsensorelement gelieferte elektrische Signale aus und ermittelt daraus, ob eine Betätigung vorliegt. Wird beispielsweise vom berührungssensitiven Sensorelement ein entsprechendes Betätigungssignal geliefert, vom zugeordneten Kraftsensorelement jedoch nicht, so kann mittels der Auswerteeinheit entschieden werden, dass dies nicht als Betätigung gewertet wird, weil es an der entsprechenden Kraftwirkung mangelt.

Die Eingabeeinrichtung kann mehr als ein berührungssensitives Sensorelement aufweisen. Entsprechend können für jedes der berührungssensitiven Sensorelemente auch mit diesen mechanisch verbundene Kraftsensorelemente vorgesehen sein. Alternativ kann jedoch auch vorgesehen sein, dass die berührungssensitiven Sensorelemente an einer gemeinsamen Oberfläche bewegbar gelagert sind, und lediglich ein einziges Kraftsensorelement für sämtliche berührungssensitiven Sensorelemente vorgesehen sein. Dadurch kann die Erfindung auf einfache Weise mit lediglich einem einzigen Kraftsensorelement für eine Mehrzahl von berührungssensitiven Sensorelementen angewendet werden. Natürlich können auch Kombinationen hiervon vorgesehen sein.

Eine Weiterbildung der Erfindung sieht vor, dass das Kraftsensorelement ausgebildet ist, ein elektrisches Kraftsignal zu erzeugen und entsprechend der einwirkenden Kraft dem Kraftsignal einen Wert aus einer vorgegebenen Mehrzahl von wenigstens drei Werten gemäß einer eindeutigen Zuordnungsvorschrift zuzuordnen. Dadurch ist es möglich, dass eine nachfolgende Einheit wie zum Beispiel die Auswerteeinheit das Kraftsignal auswertet und entsprechend einem Wert des Kraftsignals auf eine tatsächlich anliegende Kraft schließen kann. Vorzugsweise ist jedem Wert des Kraftsignals genau ein Wert der einwirkenden Kraft zugeordnet. Die Zuordnung kann kontinuierlich sein, beispielsweise indem eine unendliche Mehrzahl von Werten vorgesehen ist, entsprechend einer analogen Kraftmessung. Es kann aber auch vorgesehen sein, dass das Kraftsignal ein kodiertes digitales Signal ist. Dabei kann auch eine Rasterung durch eine endliche Mehrzahl von Werten für das Kraftsignal vorgesehen sein. Dies ermöglicht eine Diskretisierung des Kraftsignals, sodass es auf einfache Weise einer digitalen Nutzung zur Verfügung steht. Besonders vorteilhaft ist eine Zuordnung die linear ist, sodass zwischen dem Kraftsignal und der einwirkenden Kraft eine Proportionalität vorliegt. Gleichwohl kann zum Beispiel in Abhängigkeit von Eigenschaften des Kraftmesssensors auch eine andere Abhängigkeit vorliegen.

Besonders vorteilhaft erweist es sich, wenn das berührungssensitive Sensorelement in Richtung des Kraftsensorelements mit einer Kraft beaufschlagt ist. Diese Ausgestaltung sieht also vor, dass in Richtung der Betätigungskraft durch einen Bedienenden eine ergänzende Kraftwirkung auf das berührungssensitive Sensorelement erfolgt, die zugleich auch auf das Kraftsensorelement einwirkt. Dies hat den Vorteil, dass insbesondere in einer Umgebung, in der hohe Beschleunigungen auftreten, die mechanische Kopplung auch dann erreicht werden kann, wenn das berührungssensitive Sensorelement am Kraftsensorelement lediglich anliegt. Klappergeräusche und dergleichen sowie Funktionsstörungen können dadurch reduziert werden. Darüber hinaus erlaubt es diese Ausgestaltung, den Kraftsensor in einen vorgebbaren Betriebszustand zu bringen, in dem eine Kraftmessung besonders vorteilhaft vorgenommen werden kann.

Die Erfindung lässt sich darüber hinaus auch mit Aktuatoren kombinieren, die es erlauben, eine haptische Rückwirkung des berührungssensitiven Sensorelements zu erzeugen. Besonders vorteilhaft ist dazu vorgesehen, dass die haptische Rückwirkung erst nach Erfassen der Betätigung mittels des Aktuators auf das berührungssensitive Sensorelement gegeben wird. Dadurch kann eine zeitliche Entkopplung erreicht werden.

Eine Weiterbildung sieht vor, dass das berührungssensitive Sensorelement einen Kontaktierungsvorsprung in Richtung des Kraftsensorelements aufweist, welcher das Kraftsensorelement mechanisch koppelt. Damit ist es möglich, Abstände zwischen dem berührungssensitiven Sensorelement und dem Kraftsensorelement zu überbrücken. Mittels des Kontaktierungsvorsprungs kann ferner eine Einstellbarkeit erreicht werden, die es erlaubt, die mechanische Kopplung zwischen dem berührungssensitiven Sensorelement und dem Kraftsensorelement in Abhängigkeit der räumlichen Umgebungsbedingungen, in denen diese Elemente angeordnet sind, zu berücksichtigen. Ferner wird vorgeschlagen, dass die Eingabeeinrichtung einen Aktuator aufweist, der mit dem berührungssensitiven Sensorelement mechanisch gekoppelt ist.

Eine vorteilhafte Ausgestaltung sieht weiterhin vor, dass das berührungssensitive Sensorelement einstückig mit dem Kraftsensorelement ausgebildet ist. Dadurch kann eine kompakte Baueinheit geschaffen werden, die einfach weiterverarbeitet werden kann. Darüber hinaus eignet sich diese Ausgestaltung ferner dazu, geprüfte Baueinheiten bereitzustellen, deren Zusammenspiel sich bei der Weiterverarbeitung im Wesentlichen nicht mehr ändert. Dadurch kann die Fertigung weiter verbessert werden, insbesondere hinsichtlich der Zuverlässigkeit.

Gemäß einer weiteren Ausgestaltung wird vorgeschlagen, dass zumindest das Kraftsensorelement feuchtigkeitsdicht angeordnet ist. Durch die feuchtigkeitsdichte Anordnung kann erreicht werden, dass das Kraftsensorelement im bestimmungsgemäßen Betrieb auch bei unterschiedlichen atmosphärischen Bedingungen zuverlässig und weitgehend ohne Drift seine Kraftmessung durchführen kann. Insgesamt kann dadurch die Zuverlässigkeit weiter verbessert werden.

Gemäß der Erfindung wird vorgeschlagen, dass das Kraftsensorelement eine kapazitive Messeinheit aufweist. Mittels der kapazitiven Messeinheit kann auf einfache und zuverlässige Weise eine Kraft ermittelt werden. Zu diesem Zweck kann beispielsweise eine elastische, elektrisch leitfähige Membran gegenüber einer weiteren elektrisch leitfähigen Fläche elektrisch isoliert angeordnet sein. Eine zu messende Kraft wirkt auf die Membran ein, sodass der Abstand zwischen der Membran und der Gegenfläche entsprechend der Kraft und der Elastizität der Membran verändert wird. Diese Änderung kann mittels eines Kapazitätsmessgeräts ermittelt werden. Durch Vergleich einer gemessenen Kapazität mit beispielsweise vorab gespeicherten Werten kann dann auf die tatsächlich einwirkende Kraft geschlossen werden. Das Kraftsensorelement mit einer solchen kapazitiven Messeinheit liefert dann ein entsprechendes Kraftsignal als Ausgangssignal.

Gemäß der Erfindung wird vorgeschlagen, dass das Kraftsensorelement eine weitere kapazitive Messeinheit als Referenzeinheit aufweist, wobei das Kraftsensorelement eingerichtet ist, das Kraftsignal unter Berücksichtigung eines von der Referenzeinheit bereitgestellten Referenzsignals zu erzeugen. Die Referenzeinheit kann zum Beispiel eine identische kapazitive Messeinheit sein. Diese wird jedoch mit einer unveränderbaren konstanten Kraft beaufschlagt, sodass sie vorzugsweise immer gleich belastet ist. Durch Vergleich eines Messergebnisses der Referenzeinheit mit einem Messergebnis der kapazitiven Messeinheit kann dann auf die Kraftdifferenz geschlossen werden. Unter Berücksichtigung der fest voreingestellten Kraft die Referenzeinheit kann dann die tatsächlich einwirkende Kraft ermittelt und ein entsprechendes Kraftsignal ausgegeben werden. Zu diesem Zweck erzeugt die Referenzeinheit ein Referenzsignals, welches zur Ermittlung des Kraftsignals vom Kraftmesssensor berücksichtigt wird. Hierdurch können Drift, insbesondere Langzeitdrift, Temperatureinflüsse, Feuchtigkeitseinflüsse und/oder dergleichen kompensiert werden. Insgesamt erlaubt es diese Ausgestaltung, die Messgenauigkeit weiter zu erhöhen.

Demgemäß wird mit einer Weiterbildung vorgeschlagen, dass die Eingabeeinrichtung eine Auswerteeinheit aufweist, die zum Ermitteln der manuellen Betätigung sowohl ein vom berührungssensitiven Sensorelement geliefertes Berührungssignal als auch das vom Kraftsensorelement gelieferte Kraftsignal empfängt und kombiniert auswertet, wobei die Auswerteeinheit eingerichtet ist, in Abhängigkeit von einem Ergebnis des kombinierten Auswertens ein Betätigungssignal auszugeben. Die kombinierte Auswertung kann vorsehen, dass ein Verknüpfungssignal gebildet wird, beispielsweise durch Addition der Einzelsignale, und dieses Verknüpfungssignal mit einem Vergleichswert verglichen wird. In Abhängigkeit von einem Vergleichsergebnis wird dann das Betätigungssignal erzeugt, welches eine erfasste manuelle Betätigung anzeigt. Darüber hinaus können das Kraftsignal und das Berührungssignal auch mit jeweils mit einem diesen Signalen zugeordneten jeweiligen Vergleichswert verglichen werden. In Abhängigkeit von den beiden Vergleichsergebnissen wird dann das Betätigungssignal erzeugt. Natürlich kann auch eine Kombination hiervon vorgesehen sein.

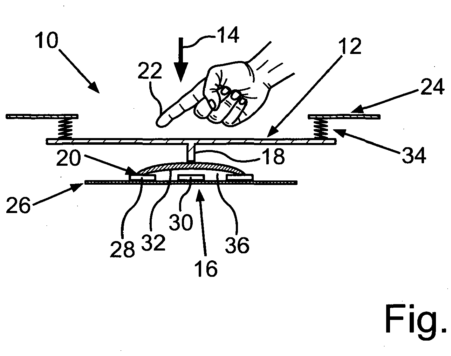

Weitere Vorteile und Merkmale sind der folgenden Beschreibung eines Ausführungsbeispiels anhand von Figuren zu entnehmen. Das Ausführungsbeispiel dient lediglich der Erläuterung der Erfindung und ist für diese nicht beschränkend. In der Figur verwendete Bezugszeichen bezeichnen gleiche Bauteile und Funktionen.

Es zeigt die einzige Figur eine Eingabeeinrichtung gemäß der Erfindung, bei der ein Touchpad als berührungssensitives Sensorelement mechanisch mit einem Kraftsensorelement gekoppelt ist.

Die einzige Figur zeigt eine Eingabeeinrichtung 10, die zum Ermitteln einer manuellen Betätigung dient. Die Eingabeeinrichtung 10 weist ein Touchpad 12 als berührungssensitives Sensorelement auf, welches in eine Betätigungsrichtung 14 einer manuellen Betätigung bewegbar gelagert ist. Das Touchpad 12 ist vorliegend als kapazitives Touchpad ausgebildet und an eine nicht dargestellte Auswerteeinheit elektrisch angeschlossen. Das Touchpad 12 detektiert eine Betätigung mittels eines Fingers 22 eines Benutzers und liefert ein entsprechendes Signal an die Auswerteeinheit. Das Touchpad 12 ist vorliegend als starre, plattenförmige Baueinheit ausgebildet und in Betätigungsrichtung 14 verschiebbar gelagert. Die verschiebbare Lagerung ist hier nicht weiter dargestellt, weil sie dem Grunde nach beliebig ausgestaltet sein kann, ohne den Kerngedanken der Erfindung zu verändern. Das Touchpad 12 ist in einer nicht bezeichneten Öffnung eines Gehäuses 24 der Eingabeeinrichtung 10 angeordnet. Wird mittels des Fingers 22 eine Druckkraft in Betätigungsrichtung 14 auf das Touchpad 12 ausgeübt, so verschiebt sich die in der Figur dargestellte Lage des Touchpads 12 gegenüber dem Gehäuse 24 ebenfalls in die Betätigungsrichtung 14. Das Funktionsprinzip des Touchpads 12 basiert vorliegend auf einem Erfassen von kapazitiven Änderungen. Alternativ kann jedoch auch ein Touchpad zum Einsatz kommen, dessen Funktionsprinzip auf einem Erfassen von optischen Änderungen basiert.

In der Figur ist unterhalb des Touchpads 12 ein Kraftsensorelement 16 angeordnet. Das Kraftsensorelement 16 ist mechanisch gekoppelt mit dem Touchpad 12 über einen mit dem Touchpad 12 rückseitig verbundenen Stößel 18 als Kontaktierungsvorsprung. Der Stößel 18 weist vom Touchpad 12 in Richtung des Kraftsensorelements 16. Das Touchpad 12 und der Stößel 18 sind vorliegend einstückig miteinander ausgebildet. Die Anordnung ist derart gewählt, dass der StöOel 18 am Kraftsensorelement 16 anliegt.

Das Kraftsensorelement 16 weist eine Leiterplatte 26 auf, auf der eine Leiterbahnanordnung vorgesehen ist, die zusammen mit einem Deckel 32 aus Messingblech eine kapazitive Messeinheit 22 bildet. Zu diesem Zweck weist die Leiterplatte eine ringförmig ausgebildete Leiterbahn 28 auf, innerhalb welcher eine weitere kreisförmige Leiterbahn 30 elektrisch isoliert von der Leiterbahn 28 angeordnet ist. Der Deckel 32 ist ebenfalls wie die Leiterbahn 28 mit einem vergleichbaren Radius kreisförmig ausgebildet, sodass sein äußerer Umfang auf der Leiterbahn 28 aufliegt. Zugleich ist der Deckel 32 gewölbt, sodass ein Abstand zwischen dem Deckel 32 und der Leiterbahn 30 besteht. Durch diese Anordnung ist zwischen den Leiterbahnen 28, 30 eine Kapazität ausgebildet, die mittels einer nicht dargestellten Kapazitätsmesseinheit gemessen werden kann. Die Kapazitätsmesseinheit liefert ein entsprechendes Kraftsignal ebenfalls an die Auswerteeinheit.

Die Kapazität der kapazitiven Messeinheit 20 ist davon abhängig, wie groß der Abstand zwischen der Leiterbahn 30 und dem Deckel 32 ist. Wird mit dem Stößel 18 eine in Betätigungsrichtung 14 wirkende Druckkraft mittels des Fingers 22 auf das Touchpad 12 ausgeübt, so erfolgt entsprechend der Krafteinwirkung eine Verschiebung des Touchpads 12 und des mit ihm verbundenen Stößels 18. Dadurch drückt der Stößel 18 auf den Deckel 32, sodass dessen Wölbung reduziert wird. Insgesamt wird dadurch der Abstand zwischen dem Deckel 32 und der Leiterbahn 30 reduziert, sodass sich die Kapazität der kapazitiven Messeinheit 20 erhöht. Entsprechend erzeugt die kapazitive Messeinheit 20 ein entsprechendes Signal, welches an die Auswerteeinheit übermittelt wird.

Die Auswerteeinheit empfängt die Signale des Touchpads 12 und des Kraftsensorelements 16 und erzeugt ein Steuersignal nur dann, wenn sowohl ein hinreichendes Signal des Touchpads 12 als auch des Kraftsensorelements 16 erfasst worden sind. Zu diesem Zweck können die Signale jeweils mit einem Vergleichswert verglichen werden, wobei das Steuersignal lediglich dann erzeugt wird, wenn jedes der Signale für sich genommen den ihm jeweils zugeordneten Vergleichswert überschreitet.

Um eine zuverlässige Verbindung zwischen dem Stößel 18 und dem Deckel 32 zu gewährleisten, ist ferner vorgesehen, dass das Touchpad 12 gegenüber dem Gehäuse 24 in Richtung des Kraftsensorelements 16 mit einer Kraft beaufschlagt ist. Zu diesem Zweck sind Vorspannfedern 34 vorgesehen, die zwischen dem Gehäuse 24 und dem Touchpad 12 angeordnet sind. Die Vorspannfedern 34 erzeugen also eine Vorspannung in die Betätigungsrichtung 14, das heißt, in die gleiche Richtung, in die auch eine Druckkraft wirkt, die ein Nutzer mit dem Finger 22 auf das Touchpad 12 aufbringt, um eine Betätigungsfunktion zu aktivieren.

Nicht dargestellt in der Figur ist, dass die kapazitive Messeinheit 20 gegen Feuchtigkeit geschützt ist. Zu diesem Zweck ist ein Hohlraum 36, der zwischen dem Deckel 32 und der Leiterplatte 26 ausgebildet ist, mit einem elastischen, komprimierbaren Kunststoff ausgefüllt. Hierdurch ist sichergestellt, dass das Eintreten von Feuchtigkeit beziehungsweise Flüssigkeit in den Hohlraum 36 weitgehend verhindert ist. Das Eintreten von Flüssigkeit beziehungsweise Feuchtigkeit kann nämlich aufgrund von abweichenden Dielektrizitätseigenschaften die Kapazität der kapazitiven Messeinheit 20 verändern beziehungsweise verfälschen, sodass die zuverlässige Funktion beeinträchtigt werden könnte. Durch die Abdichtfunktion ist dies nicht mehr möglich, sodass eine dauerhaft zuverlässige Funktion der kapazitiven Messeinheit 20 erreicht werden kann.

Der Aufbau, wie er gerade beschrieben worden ist, hat darüber hinaus den Vorteil, dass der Stößel 18 mit dem Deckel 32 ebenso wenig fest verbunden zu sein braucht, wie der Deckel 32 mit der Leiterbahn 28. Für die bestimmungsgemäße Funktion ist es ausreichend, dass die entsprechenden Bauteile wie in der Figur dargestellt angeordnet sind. Durch die mittels der Vorspannfedern 34 erzeugte Vorspannung kann dann der Zusammenhalt des Aufbaus erreicht werden.

Das Ausführungsbeispiel dient lediglich der Erläuterung der Erfindung ist für diese nicht beschränkend. Natürlich können Funktionen insbesondere auch bezüglich der Auswertung oder der akustischen Kopplung beliebig gestaltet sein, ohne den Gedanken der Erfindung zu verlassen. Darüber hinaus ist die Erfindung natürlich nicht nur für die Anwendung bei Fahrzeugen beschränkt, sondern sie kann natürlich für beliebige Eingabeeinrichtungen, also auch für Radios, Haushaltsgeräte oder dergleichen, genutzt werden. Durch den Kraftsensor kann erreicht werden, dass die Betätigung zuverlässig erkannt werden kann.

Schließlich ist anzumerken, dass die für die erfindungsgemäße Einrichtung beschriebenen Vorteile und Merkmale sowie Ausführungsformen gleichermaßen für ein entsprechendes Verfahren gelten und umgekehrt. Folglich können für Vorrichtungsmerkmale entsprechende Verfahrensmerkmale und umgekehrt vorgesehen sein.

## Patentansprüche

1. Eingabeeinrichtung (10) zum Ermitteln einer manuellen Betätigung, mit einem berührungssensitiven Sensorelement (12), welches derart bewegbar gelagert ist, dass es bei der manuellen Betätigung in eine Betätigungsrichtung (14) bewegbar ist, wobei das berührungssensitive Sensorelement (12) mit einem Kraftsensorelement (16) mechanisch gekoppelt ist,
**dadurch gekennzeichnet, dass**
das Kraftsensorelement (16) eine kapazitive Messeinheit (20) aufweist, wobei das Kraftsensorelement (16) eine weitere kapazitive Messeinheit als Referenzeinheit aufweist, wobei das Kraftsensorelement (16) eingerichtet ist, das Kraftsignal unter Berücksichtigung eines von der Referenzeinheit bereitgestellten Referenzsignals zu erzeugen.

2. Eingabeeinrichtung nach Anspruch 1,
**dadurch gekennzeichnet, dass** das Kraftsensorelement (16) ausgebildet ist, ein elektrisches Kraftsignal zu erzeugen und entsprechend der einwirkenden Kraft dem Kraftsignal einen Wert aus einer vorgegebenen Mehrzahl von wenigstens drei Werten gemäß einer eindeutigen Zuordnungsvorschrift zuzuordnen.

3. Eingabeeinrichtung nach Anspruch 1 oder 2,
**dadurch gekennzeichnet, dass**
das berührungssensitive Sensorelement (12) in Richtung des Kraftsensorelements (16) mit einer vorgegebenen Kraft vorgespannt ist.

4. Eingabeeinrichtung nach einem der Ansprüche 1 bis 3,
**dadurch gekennzeichnet, dass**
das berührungssensitive Sensorelement (12) einen Kontaktierungsvorsprung (18) in Richtung des Kraftsensorelements (16) aufweist, welcher das Kraftsensorelement (16) mechanisch koppelt.

5. Eingabeeinrichtung nach einem der Ansprüche 1 bis 4,
**gekennzeichnet durch**
einen Aktuator, der mit dem berührungssensitiven Sensorelement (12) mechanisch gekoppelt ist.

6. Eingabeeinrichtung nach einem der Ansprüche 1 bis 5,
**dadurch gekennzeichnet, dass**
das berührungssensitive Sensorelement (12) einstückig mit dem Kraftsensorelement (16) ausgebildet ist.

7. Eingabeeinrichtung nach einem der Ansprüche 1 bis 6,
**dadurch gekennzeichnet, dass**
zumindest das Kraftsensorelement (16) feuchtigkeitsdicht angeordnet ist.

8. Eingabeeinrichtung nach einem der Ansprüche 1 bis 7,
**gekennzeichnet durch**
eine Auswerteeinheit, die zum Ermitteln der manuellen Betätigung sowohl ein vom berührungssensitiven Sensorelement (12) geliefertes Berührungssignal als auch das vom Kraftsensorelement (16) gelieferte Kraftsignal empfängt und kombiniert auswertet, wobei die Auswerteeinheit eingerichtet ist, in Abhängigkeit von einem Ergebnis des kombinierten Auswertens ein Betätigungssignal auszugeben.

9. Kraftfahrzeug
**gekennzeichnet durch**
eine Eingabeeinrichtung (10) nach einem der vorhergehenden Ansprüche.

## Claims

1. Input device (10) for detecting a manual operation, comprising a touch-sensitive sensor element (12) which is mounted to be movable so that it can be moved during the manual operation in a direction of operation (14), wherein the touch-sensitive sensor element (12) is coupled mechanically to a force sensor element (16),
**characterised in that**
the force sensor element (16) has a capacitive measuring unit (20), wherein the force sensor element (16) has an additional capacitive measuring unit as a reference unit, wherein the force sensor element (16) is configured to produce the force signal taking into consideration a reference signal provided by the reference unit.

2. Input device according to claim 1,
**characterised in that** the force sensor element (16) is designed to produce an electrical force signal, and according to the acting force to assign to the force signal a value from a predefined plurality of at least three values according to an explicit assignment instruction.

3. Input device according to claim 1 or 2,
**characterised in that**
the touch-sensitive sensor element (12) is pretensioned in the direction of the force sensor (16) by means of a predefined force.

4. Input device according to any of claims 1 to 3,
**characterised in that**
the touch-sensitive sensor element (12) comprises a contacting projection (18) in the direction of the force sensor element (16) which mechanically couples the force sensor element (16).

5. Input device according to any of claims 1 to 4,
**characterised by**
an actuator which is mechanically coupled to the touch-sensitive sensor element (12).

6. Input device according to any of claims 1 to 5,
**characterised in that**
the touch-sensitive sensor element (12) is formed in one piece with the force sensor element (16).

7. Input device according to any of claims 1 to 6,
**characterised in that**
at least the force sensor element (16) is arranged to be moisture-proof.

8. Input device according to any of claims 1 to 7,
**characterised by**
an evaluation unit which for detecting the manual operation receives and evaluates in combination a touch signal delivered by the touch-sensitive sensor element (12) and the force signal delivered by the force sensor element (16), wherein the evaluation unit is configured to emit an operating signal depending on a result of the combined evaluation.

9. Motor vehicle,
**characterised by**
an input device (10) according to any of the preceding claims.

## Revendications

1. Dispositif d'entrée (10) pour déterminer un actionnement manuel, avec un élément capteur tactile (12) qui est logé, mobile, de telle sorte qu'il peut être déplacé dans une direction d'actionnement (14) lors de l'actionnement manuel, dans lequel l'élément capteur tactile (12) est couplé mécaniquement avec un élément capteur de force (16),
**caractérisé en ce que**
l'élément capteur de force (16) comporte une unité de mesure capacitive (20), dans lequel l'élément capteur de force (16) comporte une autre unité de mesure capacitive comme unité de référence, dans lequel l'élément capteur de force (16) est réalisé pour produire le signal de force en tenant compte d'un signal de référence fourni par l'unité de référence.

2. Dispositif d'entrée selon la revendication 1,
**caractérisé en ce que** l'élément capteur de force (16) est conçu pour produire un signal de force électrique et pour, en fonction de la force agissante, associer au signal de force une valeur parmi une multiplicité prédéterminée d'au moins trois valeurs selon une règle d'association univoque.

3. Dispositif d'entrée selon la revendication 1 ou 2,
**caractérisé en ce que**
l'élément capteur tactile (12) est précontraint en direction de l'élément capteur de force (16) avec une force prédéterminée.

4. Dispositif d'entrée selon l'une quelconque des revendications 1 à 3,
**caractérisé en ce que**
l'élément capteur tactile (12) comporte en direction de l'élément capteur de force (16) une partie en saillie de contact (18) qui couple mécaniquement l'élément capteur de force (16).

5. Dispositif d'entrée selon l'une quelconque des revendications 1 à 4,
**caractérisé par**
un actionneur qui est couplé mécaniquement à l'élément capteur tactile (12).

6. Dispositif d'entrée selon l'une quelconque des revendications 1 à 5,
**caractérisé en ce que**
l'élément capteur tactile (12) est conçu d'un seul tenant avec l'élément capteur de force (16).

7. Dispositif d'entrée selon l'une quelconque des revendications 1 à 6,
**caractérisé en ce**
**qu'**au moins l'élément capteur de force (16) est agencé de manière à être étanche à l'humidité.

8. Dispositif d'entrée selon l'une quelconque des revendications 1 à 7,
**caractérisé par**
une unité d'évaluation qui, pour déterminer l'actionnement manuel, reçoit aussi bien un signal de contact fourni par l'élément capteur tactile (12) que le signal de force fourni par l'élément capteur de force (16) et les évalue de manière combinée, laquelle unité d'évaluation est réalisée pour délivrer un signal d'actionnement en fonction d'un résultat de l'évaluation combinée.

9. Véhicule automobile
**caractérisé par**
un dispositif d'entrée (10) selon l'une quelconque des revendications précédentes.
